# EUROPEAN PATENT APPLICATION

(11) **EP 4 455 684 A1**
(43) Date of publication of application: **30.10.2024**
(21) Application number: 22909594.8
(22) Date of filing: 17.11.2022
(51) Int. Cl.: G01R 19/00

(54) **CURRENT SENSOR**

(30) Priority: 21.12.2021 CN 202111572274
(71) Applicant: MultiDimension Technology Co., Ltd., Jiangsu 215634 (CN)
(72) Inventor: LIU, Mingfeng, Zhangjiagang, Jiangsu 215634 (CN); SHI, Ran, Zhangjiagang, Jiangsu 215634 (CN); XUE, Songsheng, Zhangjiagang, Jiangsu 215634 (CN)
(74) Representative: HGF
(86) International application number: PCT/CN2022/132435
(87) International publication number: WO 2023/116278

(57) **Abstract**

A current sensor is disclosed. In the current sensor, a primary-side current input copper bar comprises a differential copper bar area (11) and a current shunting copper bar area (12) connected in parallel. The differential copper bar area (11) comprises a current conduction path in a U-shaped structure. The number of the current shunting copper bar area (12) is one or more. Any current shunting copper bar area (12) is placed with the differential copper bar area (11) in a same horizontal plane or in different horizontal plane. The primary-side current input copper bar is integrally formed, or is formed by connecting more than one independent copper bars. A magnetic induction module secured on a circuit board is located above the current conduction path of U-shaped structure in the differential copper bar area (11). An output of the magnetic induction module forms an output signal of the current sensor. The current sensor has a large current measurement range, adjustable sensitivity and a strong resistance to external magnetic field interference. The input and output of the sensor are electrically isolated, and it can measure alternating currents and direct currents. The current sensor's structure is simple and cost effective.

## Description

### Technical Field

Embodiments of the present invention relate to the technical field of electrical measurement, and in particular to a current sensor.

### Background

Current sensors are a type of current detection devices that can convert and output detected information of a current to be detected into an electrical signal or information in other desired forms that meet certain standard requirements, so as to meet the needs of information transmission, processing, storage, display, recording, and control. They are widely used in many fields including home appliances, smart grids, electric vehicles, wind power generation and other fields. Currently, the most widely used current sensors are magnetic current sensors, which mainly includes fluxgate current sensors, Hall current sensors, and magnetoresistive current sensors.

Fluxgate current sensors have good linearity, high accuracy, and good temperature drift performance, but require a high permeability core, which leads to a large size, complex circuit, and high cost.

Hall current sensor technology is mature, but it has low sensitivity, poor temperature drift characteristics, and small bandwidth, its magnetic field sensitivity direction being perpendicular to the plane where the Hall element is located. There are two main current input methods for Hall current sensors. One is to sense the magnetic field of the current conductor to be measured through a ring-shaped iron core, which is relatively large in size; and the other is a small chip-level current sensor, in which the current to be measured is directly input into a U-shaped copper conduction path, and the measurement range is smaller than that of the former.

Magnetoresistive current sensors mainly include anisotropic magnetoresistor AMR, giant magnetoresistor GMR, and tunnel magnetoresistor TMR current sensors. The direction of their magnetic field sensitivity is parallel to the plane where the magnetoresistive device is located, achieving high sensitivity and good linearity. However, magnetoresistive devices with a high sensitivity generally have a small saturation field, and their internal magnetoresistive sensitive elements are prone to magnetic saturation during large current measurements, resulting in a small current measurement range, which affects their scope of use. The input methods of a current to be measured of the magnetoresistive current sensor include the following: (1) Using a ring-shaped iron core to sense the magnetic field of the current conductor to be measured, which is large in size and weight. (2) Taking Allegro's ACS70331 as an example, the current to be measured is directly input into the single-layer U-shaped copper conduction path of the integrated GMR current sensor; (3) In the patent with the application number 202011547895.2, the current to be measured is input into a copper strip with a neck depression; (4) In the patent with the application number 201811455342.7, the current to be measured is input into a copper bar-type conductor to be measured with a rectangular or rounded rectangular cross-section; and in this type of input methods, it is easy for the single current input path to exceed the linear operating range of a magnetoresistive sensitive element, causing the magnetoresistive sensitive element to be easily saturated, thereby limiting the current measurement range.

### Summary of the Invention

Embodiments of the present invention provide a current sensor to solve the problems of existing current sensors including large volume and small current measurement range.

The embodiments of the present invention provide a current sensor, comprising: a primary-side current input copper bar, a magnetic induction module, and a circuit board;
the primary-side current input copper bar comprises a primary-side input terminal, a primary-side output terminal, a differential copper bar area, and a current shunting copper bar area;
the differential copper bar area and the current shunting copper bar area are electrically connected in parallel, the differential copper bar area includes a U-shaped current conduction path, the number of the current shunting copper bar areas is one or more, and any of the current shunting copper bar areas and the differential copper bar area are located in the same horizontal plane or different horizontal planes;
the number of the primary-side input terminals is one or more, the number of the primary-side output terminals is one or more, and any of the primary-side input terminals and the primary-side output terminals is electrically connected to the differential copper bar area or to the current shunting copper bar area;
the primary-side current input copper bar is formed in one of the following two ways: (1) integrally formed; (2) formed by connecting more than one independent copper bar, wherein the independent copper bar includes part or all of the primary-side input terminal, the primary-side output terminal, the differential copper bar area, and the current shunting copper bar area; and
the magnetic induction module is secured on the circuit board and is located above the U-shaped current conduction path in the differential copper bar area, and the output of the magnetic induction module forms the output signal of the current sensor.

The current sensor provided by the embodiments of the present invention has a large current measurement range, electrically isolates input and output, can measure AC and DC currents, has adjustable sensitivity, and has strong resistance to external magnetic field interference. Compared with the prior art, the current measurement range is regulated by parallel shunting the U-shaped current conduction path; therefore, the current input range can be regulated by controlling the structure, quantity, and plane of the current shunting copper bar area, thereby realizing large current measurement without an iron core and reducing the volume and weight; further, the design of the current sensor is simplified by adopting integrated processing, the structure is simple, and the production cost is reduced; it is suitable for magnetic induction units whose magnetic field sensitivity direction is perpendicular to or parallel to the plane where the magnetic induction module is located, expanding the measurement range of magnetoresistive devices with high sensitivity and small saturation field, and has the characteristics of input and output electrical isolation, capability of measuring AC and DC currents, adjustable sensitivity, and strong resistance to external magnetic field interference.

### Description of the Drawings

In order to more clearly illustrate the technical solutions in the embodiments of the present invention or the prior art, the accompanying drawings required for use in the embodiments or the prior art are briefly introduced below. Obviously, although the accompanying drawings described below are some specific embodiments of the present invention, for those skilled in the art, the basic concepts of the device structure, driving method, and manufacturing method disclosed and prompted by the various embodiments of the present invention can be expanded and extended to other structures and drawings, and there is no doubt that these should all fall within the scope of the claims of the present invention.
FIG. 1 is a schematic diagram of an existing U-shaped copper conduction path;
FIG. 2 is a schematic diagram of simulation calculation results of the x component of the magnetic field generated in FIG. 1 changing along the x axis;
FIG. 3 is a schematic diagram of simulation calculation results of the z component of the magnetic field generated in FIG. 1 changing along the x axis;
FIG. 4 is a schematic diagram of a primary-side current input copper bar according to an embodiment of the present invention;
FIG. 5 is a schematic diagram of simulation calculation results of the x component of the magnetic field generated in FIG. 4 changing along the x axis;
FIG. 6 is a schematic diagram of simulation calculation results of the z component of the magnetic field generated in FIG. 4 changing along the x axis;
FIG. 7 is a schematic diagram of another primary-side current input copper bar according to an embodiment of the present invention;
FIG. 8 is a schematic diagram of simulation calculation results of the x component of the magnetic field generated in FIG. 7 changing along the x axis;
FIG. 9 is a schematic diagram of still another primary-side current input copper bar according to an embodiment of the present invention; and
FIG. 10 is a schematic diagram of simulation calculation results of the x component of the magnetic field generated in FIG. 9 changing along the x axis;
FIG. 11 is a schematic diagram of still another primary-side current input copper bar according to an embodiment of the present invention.
FIG. 12 is a schematic diagram of simulation calculation results of the x component of the magnetic field generated in FIG. 11 changing along the x axis;
FIG. 13 is a schematic diagram showing the principle of a single-bridge differential half-bridge structure of a magnetic induction module;
FIG. 14 is a schematic diagram showing the principle of a single-bridge differential full-bridge structure of a magnetic induction module;
FIG. 15 is a schematic diagram showing the principle of a double push-pull half-bridge differential structure of a magnetic induction module;
FIG. 16 is a schematic diagram showing the principle of a double push-pull full-bridge differential structure of a magnetic induction module;
FIG. 17 is a cross-sectional view of a current sensor according to an embodiment of the present invention;
FIG. 18 is a cross-sectional view of another current sensor according to an embodiment of the present invention;
FIG. 19 is a cross-sectional view of still another current sensor according to an embodiment of the present invention;
FIG. 20 is a schematic top view of the current sensor shown in FIG. 19;
FIG. 21 is a cross-sectional view of still another current sensor according to an embodiment of the present invention;
FIG. 22 is a cross-sectional view of still another current sensor according to an embodiment of the present invention; and
FIG. 23 is a schematic top view of the current sensor shown in FIG. 22.

### Detailed Description

In order to make the purpose, technical solutions, and advantages of the present invention clearer, the technical solutions of the present invention will be clearly and completely described below through implementations with reference to the accompanying drawings in the embodiments of the present invention. Obviously, the described embodiments are some, rather than all, embodiments of the present invention. Based on the basic concepts disclosed and prompted by the embodiments of the present invention, all other embodiments obtained by those skilled in the art fall within the protection scope of the present invention.

An embodiment of the present invention provides a current sensor, which includes: a primary-side current input copper bar, a magnetic induction module, and a circuit board; the primary-side current input copper bar includes a primary-side input terminal, a primary-side output terminal, a differential copper bar area, and a current shunting copper bar area; the differential copper bar area and the current shunting copper bar area are electrically connected in parallel, the differential copper bar area includes a U-shaped current conduction path, the number of the current shunting copper bar area is one or more, and any current shunting copper bar area and the differential copper bus area are located in the same horizontal plane or different horizontal planes; the number of the primary-side input terminal is one or more, and the number of the primary-side output terminal is one or more, any one of the primary-side input terminal and the primary-side output terminal is electrically connected to the differential copper bar area or is electrically connected to the current shunting copper bar area; the primary-side current input copper bar is formed by one of the following two situations: (1) integrally formed; (2) formed by connecting more than one independent copper bar, and the independent copper bar includes part or all of the primary-side input terminal, the primary-side output terminal, the differential copper bar area, and the current shunting copper bar area; the magnetic induction module is secured on the circuit board, the magnetic induction module is located above the U-shaped current conduction path in the differential copper bar area, and the output of the magnetic induction module forms the output signal of the current sensor.

As mentioned above, the current sensor converts the current to be measured into the input magnetic field of the magnetic induction module through the primary-side current input copper bar, realizing large current measurement without the need for an iron core, reducing the volume and weight, having a simple structure and low processing cost, and expanding the measurement range of magnetoresistive devices with high sensitivity and small saturation field. It has the characteristics of input and output electrical isolation, capability of measuring AC and DC currents, adjustable sensitivity, and strong resistance to external magnetic field interference.

Optionally, the magnetic induction module adopts one of the following three cases:
(1) The magnetic induction module includes at least a first magnetic induction unit and a second magnetic induction unit therein, the first magnetic induction unit and the second magnetic induction unit are located respectively above two current conduction paths with a parallel position relationship in the U-shaped current conduction path, the first magnetic induction unit and the second magnetic induction unit sense the magnetic field generated by the primary-side current input copper bar in a differential manner and generate a differential voltage signal, and the magnetic field sensitivity direction of the magnetic induction unit used by the current sensor is parallel to the plane where the magnetic induction module is located;
(2) the magnetic induction module includes at least a third magnetic induction unit therein, the vertical projection position of the third magnetic induction unit is located at the internal side of the U-shaped enclosed area of the U-shaped current conduction path, the third magnetic induction unit directly senses the magnetic field generated by the primary-side current input copper bar and generates a voltage signal, and the magnetic field sensitivity direction of the magnetic induction unit used by the current sensor is perpendicular to the plane where the magnetic induction module is located;
(3) the magnetic induction module includes at least a third magnetic induction unit and a fourth magnetic induction unit therein, the vertical projection position of the fourth magnetic induction unit is located at an external side of the U-shaped enclosed area of the U-shaped current conduction path, the third magnetic induction unit and the fourth magnetic induction unit sense the magnetic field generated by the primary-side current input copper bar in a differential manner and generate a differential voltage signal, and the magnetic field sensitivity direction of the magnetic induction unit used by the current sensor is perpendicular to the plane where the magnetic induction module is located.

Optionally, the first magnetic induction unit and the second magnetic induction unit respectively include one or more magnetoresistive bridge arms, and each magnetoresistive bridge arm is composed of one or more magnetoresistance sensitive elements connected in series and in parallel;
in the first magnetic induction unit and the second magnetic induction unit, the bridge structure adopted by any magnetic induction unit is one of a differential half-bridge structure, a differential full-bridge structure, a double push-pull half-bridge differential structure, and a double push-pull full-bridge differential structure:
(1) the differential half-bridge structure is a single bridge, and the first magnetic induction unit and the second magnetic induction unit together constitute the same single-bridge differential half-bridge structure and form an output signal of the differential half-bridge structure;
(2) the differential full-bridge structure is a single bridge, and the first magnetic induction unit and the second magnetic induction unit together constitute the same single-bridge differential full-bridge structure and form an output signal of the differential full-bridge structure;
(3) in the double push-pull half-bridge differential structure, the first magnetic induction unit and the second magnetic induction unit both adopt a push-pull half-bridge structure and each form a voltage output signal, and the voltage output signals of the two push-pull half bridge structures differentially form an output signal of the double push-pull half-bridge differential structure; and
(4) in the double push-pull full-bridge differential structure, the first magnetic induction unit and the second magnetic induction unit both adopt a push-pull full-bridge structure and each form a voltage output signal, and the voltage output signals of the two push-pull full-bridge structures differentially form an output signal of the double push-pull full-bridge differential structure.

Optionally, the primary-side current input copper bar is respectively electrically isolated from the magnetic induction module and the circuit board.

Optionally, the magnetic induction module also includes a signal conditioning circuit, and the signal conditioning circuit adopts one of an open-loop signal conditioning circuit and a closed-loop signal conditioning circuit.

The above is the main idea of the present invention. The current sensor provided by the embodiment of the present invention will be briefly described below in comparison with the prior art and in combination with the accompanying drawings and some simulation results.

The following is a brief description of primary-side current input copper bars of different designs. In the embodiment of the present invention, the primary-side current input copper bar may also be referred to as a primary-side current conductor or a copper primary conduction path, which mainly serves to introduce a current to be measured into the current sensor. The U-shaped structure in the embodiment of the present invention refers to a structure in which the current conduction path has a current anti-parallel position relationship, and thus includes but is not limited to similar shapes such as "Ω" type, "n" type, etc., which use acute angles, right angles, obtuse angles, or rounded angles as turning points.

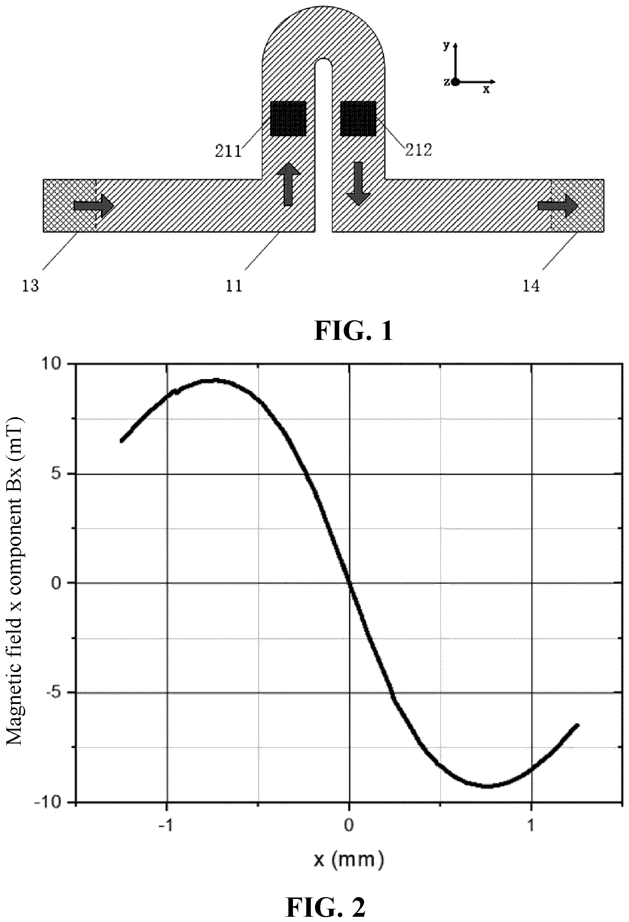

Refer to Fig. 1, which is a schematic diagram of an existing U-shaped copper conduction path. As shown in FIG. 1, the existing U-shaped copper conduction path is a single-layer U-shaped copper conduction path, that is, a U-shaped copper bar. A current to be measured is directly input into the single-layer U-shaped copper conduction path, with the horizontal rightward direction in the plane of the U-shaped copper bar as the positive direction of the x axis, the vertical upward direction in the plane of the U-shaped copper bar as the positive direction of the y axis, and the direction perpendicular to the plane of the U-shaped copper bar as the z-axis direction. The two magnetic induction units 211 and 212 are located in the same plane and are also located above the U-shaped copper bar, that is, the vertical projection of the U-shaped copper bar along the z direction covers the two magnetic induction units 211 and 212.

Assuming that the current to be measured is 50A, the current to be measured is input into the U-shaped copper bar. Through finite element simulation calculation and analysis, the current to be measured generates a magnetic field in the plane of the magnetic induction units above the U-shaped copper bar.

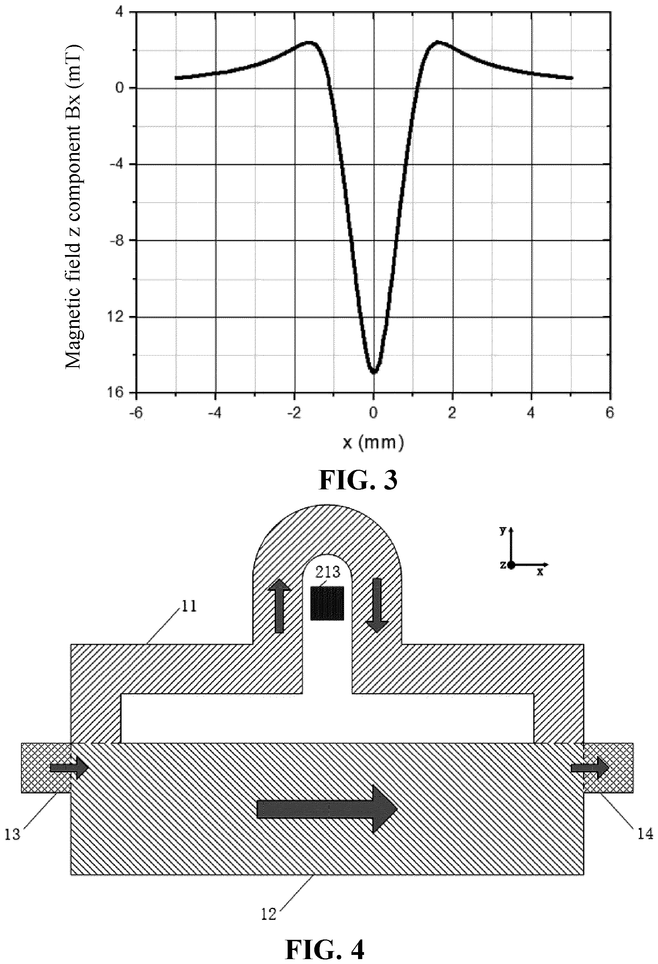

Reference is made to FIG. 2, which is a schematic diagram showing the simulation calculation results of the x component of the magnetic field changing along the x axis. Reference is made to FIG. 3, which is a schematic diagram showing the simulation calculation results of the z component of the magnetic field changing along the x axis. It can be seen from FIG. 2 and FIG. 3 that the x component of the magnetic field generated by the current to be measured varies in the range of -9 mT to +9 mT along the x axis, and the z component of the magnetic field generated by the current to be measured varies in the range of -15 mT to +2.5 mT along the x axis.

Referring to FIG. 4, which is a schematic diagram of a primary-side current input copper bar according to an embodiment of the present invention. In this embodiment, the primary-side current input copper bar includes a differential copper bar area 11, the differential copper bar area 11 is provided with the U-shaped current conduction path as shown in FIG. 1, the primary-side current input copper bar also includes a current shunting copper bar area 12, and the differential copper bar area 11 and the current shunting copper bar area 12 are located in the same plane and are electrically connected in parallel. The primary-side current input copper bar further includes a primary-side input terminal 13 and a primary-side output terminal 14. In other embodiments, the number of the current shunting copper bar areas may be more than one, and the current shunting copper bar area and the differential copper bar area may be located on the same horizontal plane or on different horizontal planes.

As shown in FIG. 4, optionally, the magnetic induction module includes at least a third magnetic induction unit 213 therein, the vertical projection position of the third magnetic induction unit 213 is located at the internal side of the U-shaped enclosed area of the U-shaped current conduction path 11, the third magnetic induction unit 213 directly senses the magnetic field generated by the primary-side current input copper bar and generates a voltage signal, and the magnetic field sensitivity direction of the magnetic induction unit used by the current sensor is perpendicular to the plane where the magnetic induction module is located; The third magnetic induction unit 213 and the U-shaped current conducting path 11 are located on the same plane.

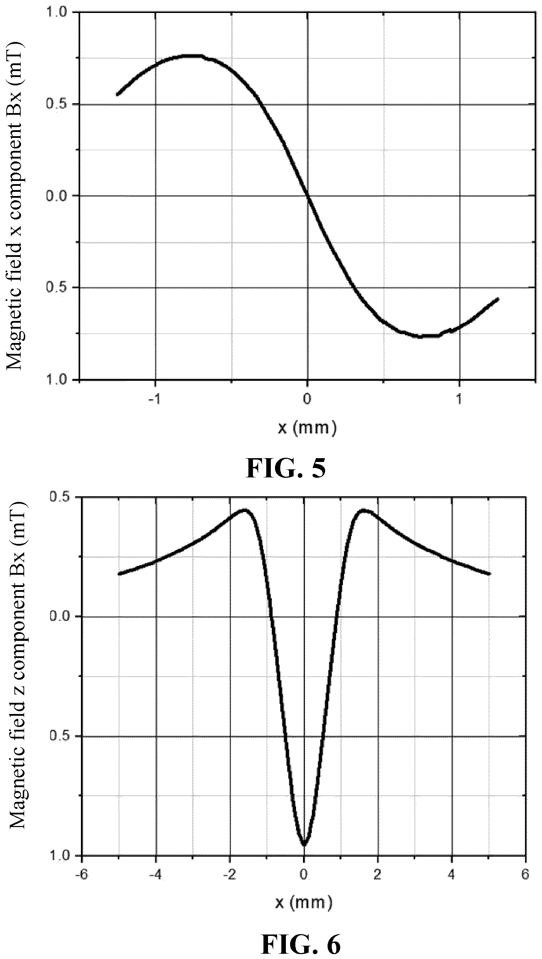

Assuming that the current to be measured is 50A, which is the same as FIG. 1, the current to be measured is input into the primary-side current input copper bar. Through finite element simulation calculation and analysis, the current to be measured generates a magnetic field in the plane of the magnetic induction units above the primary-side current input copper bar. Reference is made to FIG. 5, which is a schematic diagram showing the simulation calculation results of the x component of the magnetic field generated in FIG. 4 changing along the x axis. Reference is made to FIG. 6, which is a schematic diagram showing the simulation calculation results of the z component of the magnetic field generated in FIG. 4 changing along the x axis. It can be seen from FIG. 5 and FIG. 6 that the magnitude of the magnetic field generated by the current to be measured is significantly reduced, the range of the x component of the magnetic field generated by the current to be measured changing along the x axis is reduced to -0.75mT to +0.75mT, and the range of the z component of the magnetic field generated by the current to be measured changing along the x axis is reduced to -0.95mT to +0.45mT.

Compared with FIG. 1, for a magnetic induction unit with the same magnetic field measurement range, the structure shown in FIG. 4 can achieve an increase in the current measurement range. It can be seen from the simulation results of the z component of the magnetic field in FIG. 6 that the x component and the z component of the magnetic field generated by the primary-side current input copper bar at different positions along the x axis direction in this embodiment have obvious changes. Therefore, the current can be detected by placing the magnetic induction unit whose sensitivity direction is perpendicular to the z direction at the position where the x coordinate is zero and using non-differential measurement; in other embodiments, the current can also be detected by placing the magnetic induction unit whose sensitivity direction is along the in-plane x axis in the plane at different positions and using differential measurement.

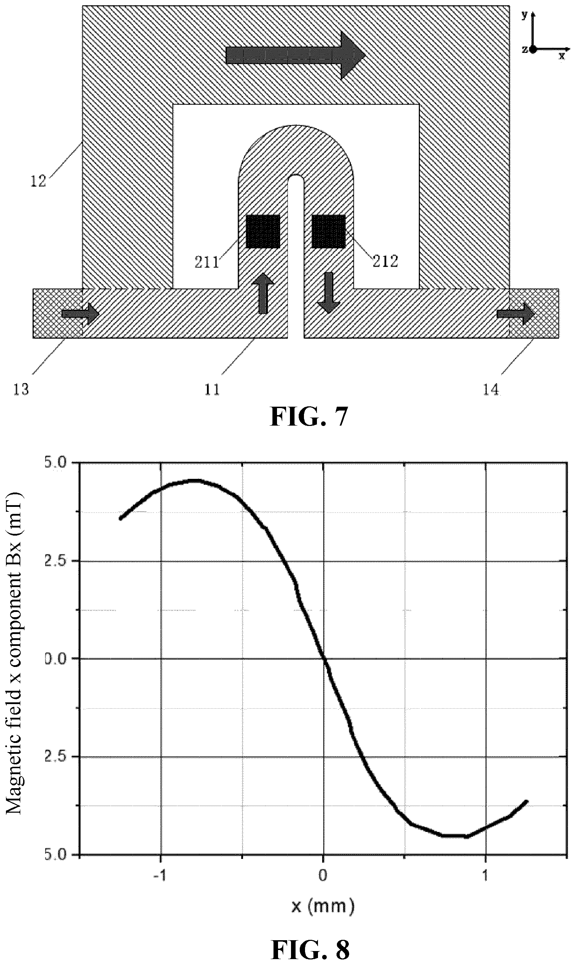

Referring to FIG. 7, a schematic diagram of another primary-side current input copper bar provided in an embodiment of the present invention is shown; referring to FIG. 8, a schematic diagram of simulation calculation results of the x component of the magnetic field generated in FIG. 7 changing along the x axis is shown. In this embodiment, the differential copper bar area 11 and the U-shaped current shunting copper bar area 12 are located in the same plane and are electrically connected in parallel.

As shown in FIG. 7, optionally, the magnetic induction module includes at least a first magnetic induction unit 211 and a second magnetic induction unit 212 therein, the first magnetic induction unit 211 and the second magnetic induction unit 212 are located respectively above two current conduction paths with a parallel position relationship in the U-shaped current conduction path 11, the first magnetic induction unit 211 and the second magnetic induction unit 212 sense the magnetic field generated by the primary-side current input copper bar in a differential manner and generate a differential voltage signal, and the magnetic field sensitivity direction of the magnetic induction unit used by the current sensor is parallel to the plane where the magnetic induction module is located. The first magnetic induction unit 211 and the second magnetic induction unit 212 are located on the same plane.

Under the same current conditions as the above embodiment, the magnitude of the magnetic field generated by the current to be measured shown in FIG. 8 is significantly reduced compared with FIG. 2. Specifically, the x component of the magnetic field generated by the current to be measured varies in the range of -4.5 mT to +4.5 mT along the x axis.

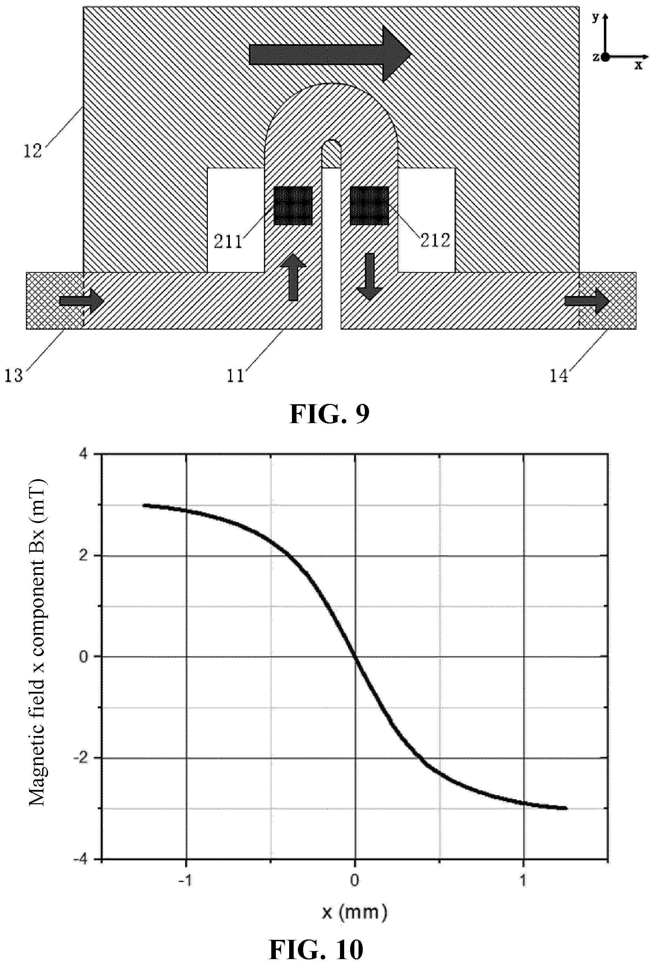

Referring to FIG. 9, a schematic diagram of still another primary-side current input copper bar provided in an embodiment of the present invention is shown; referring to FIG. 10, a schematic diagram of simulation calculation results of the x component of the magnetic field generated in FIG. 9 changing along the x axis is shown. In this embodiment, the differential copper bar area 11 and the U-shaped current shunting copper bar area 12 are located in different horizontal planes and are electrically connected in parallel.

As shown in FIG. 9, optionally, the magnetic induction module includes at least a first magnetic induction unit 211 and a second magnetic induction unit 212 therein, the first magnetic induction unit 211 and the second magnetic induction unit 212 are located respectively above two current conduction paths with a parallel position relationship in the U-shaped current conduction path 11, the first magnetic induction unit 211 and the second magnetic induction unit 212 sense the magnetic field generated by the primary-side current input copper bar in a differential manner and generate a differential voltage signal, and the magnetic field sensitivity direction of the magnetic induction unit used by the current sensor is parallel to the plane where the magnetic induction module is located. The first magnetic induction unit 211 and the second magnetic induction unit 212 are located on the same plane.

Under the same current conditions as the above embodiment, the magnitude of the magnetic field generated by the current to be measured shown in FIG. 10 is significantly reduced compared with FIG. 2. Specifically, the x component of the magnetic field generated by the current to be measured varies in the range of -3 mT to +3 mT along the x axis.

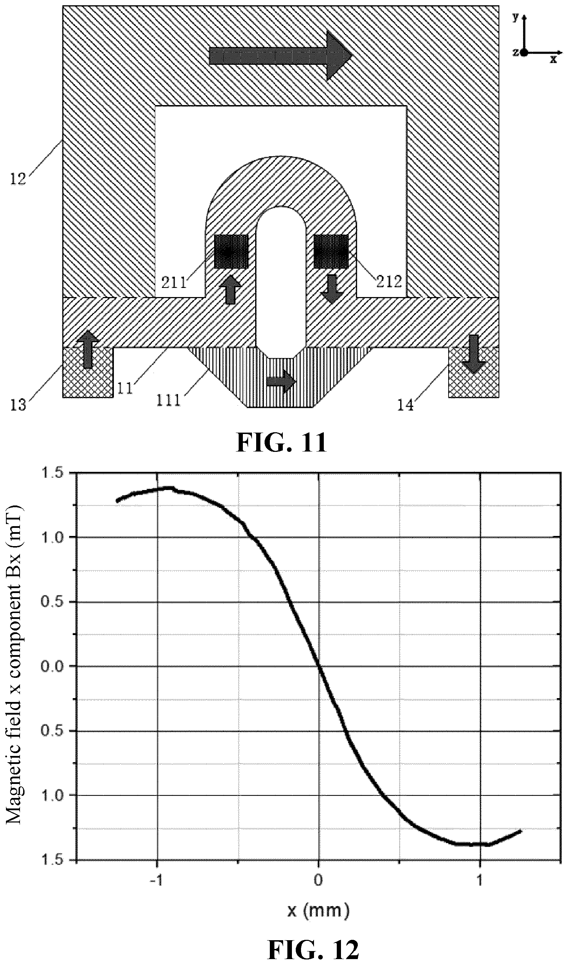

Referring to FIG. 11, a schematic diagram of still another primary-side current input copper bar provided in an embodiment of the present invention is shown; referring to FIG. 12, a schematic diagram of simulation calculation results of the x component of the magnetic field generated in FIG. 11 changing along the x axis is shown. As shown in FIG. 11, optionally, two ends of the U-shaped opening of the U-shaped current conduction path are electrically connected. The differential copper bar area 11 and the U-shaped current shunting copper bar area 12 can be located in the same horizontal plane or in different horizontal planes, and the two are electrically connected in parallel; then, the two ends of the U-shaped opening of the U-shaped current conduction path in the differential copper bar area 11 are connected to form a new current conduction path 111.

As shown in FIG. 11, optionally, the magnetic induction module includes at least a first magnetic induction unit 211 and a second magnetic induction unit 212 therein, the first magnetic induction unit 211 and the second magnetic induction unit 212 are located respectively above two current conduction paths with a parallel position relationship in the U-shaped current conduction path 11, the first magnetic induction unit 211 and the second magnetic induction unit 212 sense the magnetic field generated by the primary-side current input copper bar in a differential manner and generate a differential voltage signal, and the magnetic field sensitivity direction of the magnetic induction unit used by the current sensor is parallel to the plane where the magnetic induction module is located. The first magnetic induction unit 211 and the second magnetic induction unit 212 are located on the same plane.

Under the same current conditions as the above embodiment, the magnitude of the magnetic field generated by the current to be measured shown in FIG. 12 is significantly reduced compared with FIG. 2. Specifically, the x component of the magnetic field generated by the current to be measured varies in the range of -1.4 mT to +1.4 mT along the x axis.

The above multiple embodiments provide that the differential copper bar area in the primary-side current input copper bar is matched with the current shunting copper bar areas of different designs to form a variety of different current paths. Analysis shows that the combination of the differential copper bar area with the current shunting copper bar areas of different designs can have a significant impact on the x component of the magnetic field. Therefore, by controlling the structure, quantity, plane, and thickness of the current shunting copper bar area, the input range of the current to be measured can be controlled.

In addition, it can be seen from the above multiple embodiments that the x component of the magnetic field generated by the primary-side current input copper bars of different designs in the embodiments of the present invention in the middle area of the cross-section where the magnetic induction unit is located varies approximately linearly along the x axis and has obvious differences at different positions, and the magnetic field directions on two sides of the center are opposite, leading to an odd symmetry property. Therefore, a current can be detected by differential measurement by placing magnetic sensing units with their sensitivity directions along the in-plane x axis at different positions.

The following is a brief description of magnetic induction modules with different bridge structure designs.

Optionally, the magnetic induction module includes at least a first magnetic induction unit and a second magnetic induction unit therein, the first magnetic induction unit and the second magnetic induction unit are located respectively above two current conduction paths with a parallel position relationship in the U-shaped current conduction path, the first magnetic induction unit and the second magnetic induction unit sense the magnetic field generated by the primary-side current input copper bar in a differential manner and generate a differential voltage signal, and the magnetic field sensitivity direction of the magnetic induction unit used by the current sensor is parallel to the plane where the magnetic induction module is located;

From the example of the primary-side current input copper bar, it can be seen that when the current to be measured is input into the primary-side current input copper bar, the primary-side current input copper bar can generate a differential mode magnetic field at the positions of the first magnetic induction unit 211 and the second magnetic induction unit 212, and the magnetic field x component of the differential mode magnetic field has an obvious difference and is in opposite directions on two sides of the center of the U-shaped differential copper bar area. Without loss of generality, the following assumption is used for the explanation: assuming that the horizontal rightward direction is the positive direction of the magnetic field, the differential mode magnetic field is then directed to the right at the position of the first magnetic induction unit 211 and to the left at the position of the second magnetic induction unit 212.

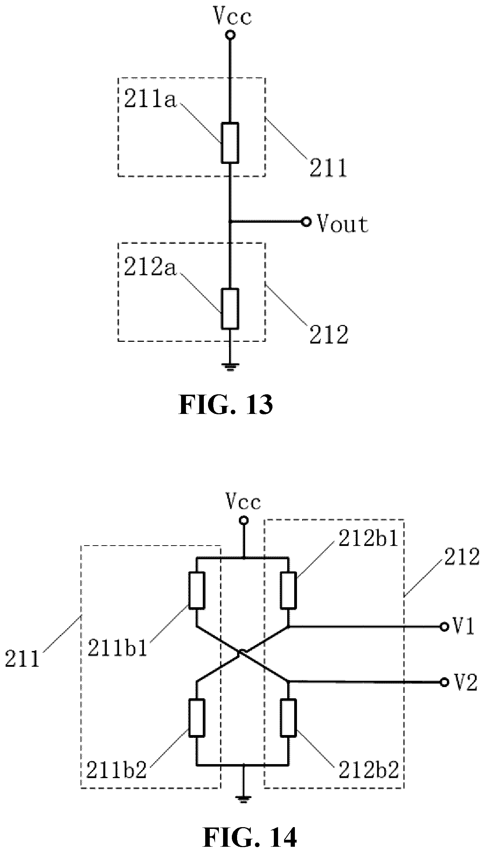

Referring to FIG. 13, it is a schematic diagram showing the principle of a single-bridge differential half-bridge structure. In the magnetic induction module, the first magnetic induction unit 211 and the second magnetic induction unit 212 have the same sensitivity direction and are both rightward, and the two magnetic induction units together form a single-bridge differential half-bridge structure. The first magnetic induction unit 211 includes a magnetoresistive bridge arm 211a, and the second magnetic induction unit 212 includes a magnetoresistive bridge arm 212a. The two magnetoresistive bridge arms form a differential half-bridge structure, and the output Vout is an output signal of the single-bridge differential half-bridge structure.

When the current to be measured is input into the primary-side current input copper bar, the magnetic induction module senses the magnetic field. When the differential mode magnetic field under the aforementioned conditions is sensed, the resistance value of the magnetoresistive bridge arm 211a decreases, and the resistance value of the magnetoresistive bridge arm 212a increases. According to the Biot-Savart law, the Vout output will change linearly with the magnitude of the current to be measured. Since the sensitivity directions of the first magnetic induction unit 211 and the second magnetic induction unit 212 of the differential half-bridge structure are the same, for an external uniform magnetic field (i.e., a common-mode magnetic field), the resistance values of the two magnetic resistance bridge arms 211a and 212a increase or decrease at the same time. At this time, the Vout output has no response, and thus has good resistance to common-mode magnetic field interference.

Referring to FIG. 14, it is a schematic diagram showing the principle of a single-bridge differential full-bridge structure. In the magnetic induction module, the first magnetic induction unit 211 and the second magnetic induction unit 212 together form a single-bridge differential full-bridge structure. Among them, the first magnetic induction unit 211 includes two magnetoresistive bridge arms 211b 1 and 211b2, and the second magnetic induction unit 212 includes two magnetoresistive bridge arms 212b1 and 212b2. The sensitivity directions of the four magnetoresistive bridge arms 211b 1, 211b2, 212b1, and 212b2 are all consistent and point to the right, and they together form a differential full-bridge structure. The output ends V1 and V2 of the differential full-bridge structure form the Vout output signal of the single-bridge differential full-bridge structure.

When the current to be measured is input into the primary-side current input copper bar, the magnetic induction module senses the magnetic field. When the differential mode magnetic field under the above conditions is sensed, the resistance values of the magnetoresistive bridge arms 211b1 and 211b2 decrease, and the resistance values of the magnetoresistive bridge arms 212b1 and 212b2 increase. As a result, the output voltage value of V1 decreases, and the output voltage value of V2 increases. The corresponding Vout output signal of the single-bridge differential full-bridge structure changes with the differential mode magnetic field. Similarly, since the sensitivity directions of the four magnetoresistive bridge arms 211b 1, 211b2, 212b1, and 212b2 are consistent, for an external uniform magnetic field (i.e., a common-mode magnetic field), the resistance values of the four magnetoresistive bridge arms 211b1, 211b2, 212b1, and 212b2 increase or decrease at the same time. At this time, the Vout output has no response, and thus has good resistance to common-mode magnetic field interference.

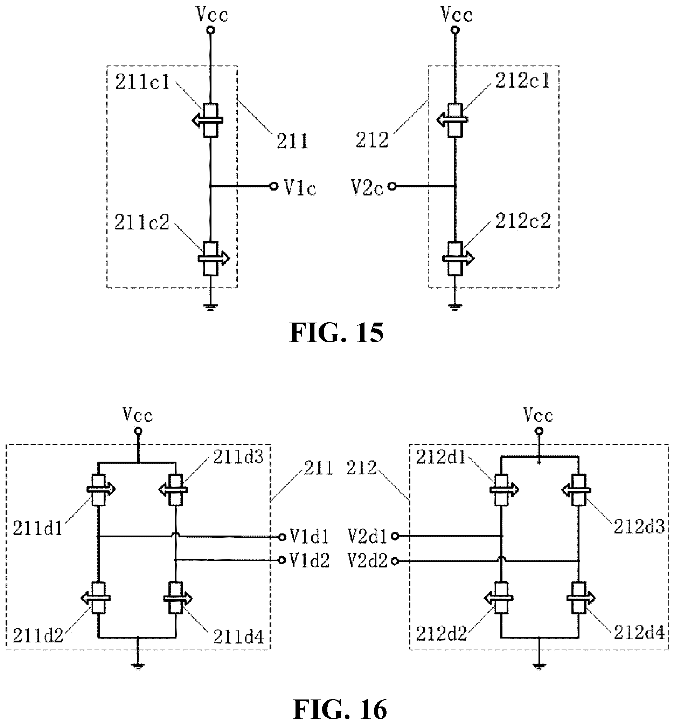

Referring to FIG. 15, it is a schematic diagram showing the principle of a double push-pull half-bridge differential structure. In the magnetic induction module, the first magnetic induction unit 211 forms a push-pull half-bridge structure, the second magnetic induction unit 212 forms a push-pull half-bridge structure, and the first magnetic induction unit 211 and the second magnetic induction unit 212 together form a double push-pull half-bridge differential structure. The first magnetic induction unit 211 and the second magnetic induction unit 212 have the same sensitivity direction and approximately the same structure and properties. Specifically, the first magnetic induction unit 211 includes two magnetoresistive bridge arms 211c1 and 211c2, and forms a push-pull half-bridge structure, which has an output of V1c; the second magnetic induction unit 212 includes two magnetoresistive bridge arms 212c1 and 212c2, and forms a push-pull half-bridge structure, which has an output of V2c. The differential signals of the output terminals V1c and V2c of the two push-pull half-bridge structures form the Vout output signal of the double push-pull half-bridge differential structure.

The sensitivity directions of the upper magnetoresistive bridge arms 21 1c1 and 212c1 in the two magnetic induction units are to the left, and the sensitivity directions of the lower magnetoresistive bridge arms 211c2 and 212c2 are to the right. When the current to be measured is input into the primary-side current input copper bar, the magnetic induction module senses the magnetic field. When the differential mode magnetic field under the above conditions is sensed, the resistance values of the magnetoresistive bridge arms 211c2 and 212c1 decrease, and the resistance values of the magnetoresistive bridge arms 211c1 and 212c2 increase. As a result, the output voltage value of V1c decreases, and the output voltage value of V2c increases. The corresponding Vout output signal of the double push-pull half-bridge differential structure changes with the differential mode magnetic field. Similarly, the double push-pull half-bridge differential structure has good resistance to common-mode magnetic field interference.

Referring to FIG. 16, it is a schematic diagram showing the principle of a double push-pull half-bridge differential structure. In the magnetic induction module, the first magnetic induction unit 211 forms a push-pull full-bridge structure, the second magnetic induction unit 212 forms a push-pull full-bridge structure, and the first magnetic induction unit 211 and the second magnetic induction unit 212 together form a double push-pull full-bridge differential structure. The first magnetic induction unit 211 and the second magnetic induction unit 212 have the same sensitivity direction and approximately the same structure and properties. Specifically, the first magnetic induction unit 211 includes four magnetoresistive bridge arms 211d1, 211d2, 211d3, and 211d4, and forms a push-pull full-bridge structure. The difference between two output terminals V1d1 and V1d2 of the push-pull full-bridge structure constitutes the output V1d of the first magnetic induction unit 211. The second magnetic induction unit 212 includes four magnetoresistive bridge arms 212d1, 212d2, 212d3, and 212d4, and forms a push-pull full-bridge structure. The difference between two output terminals V2d1 and V2d2 of the push-pull full-bridge structure constitutes the output V2d of the second magnetic induction unit 212. The differential signals of the output terminals V1d and V2d of the two push-pull full-bridge structures form the Vout output signal of the double push-pull full-bridge differential structure.

The sensitivity directions of the four magnetoresistive bridge arms 211d2, 211d3, 212d2, and 212d3 are to the left, and the sensitivity directions of the four magnetoresistive bridge arms 211d1, 211d4, 212d1, and 212d4 are to the right. When the current to be measured is input into the primary-side current input copper bar, the magnetic induction module senses the magnetic field. When the differential mode magnetic field under the above conditions is sensed, the resistance values of the four magnetic resistance bridge arms 211d1, 211d4, 212d2, and 212d3 decrease, and the resistance values of the four magnetic resistance bridge arms 211d2, 211d3, 212d1, and 212d4 increase, thereby the output voltage values of V1d2 and V2d1 are both reduced, and the output voltage values of V1d1 and V2d2 are both increased. The difference V1d between V1d1 and V1d2 is positive, and the difference V2d between V2d1 and V2d2 is negative, then the Vout output signal formed by the difference between the outputs V1d and V2d of the two push-pull full-bridge structures is numbered along with the differential mode magnetic field. Similarly, the double push-pull full-bridge differential structure has good resistance to common-mode magnetic field interference.

It can be understood that in addition to the above four typical bridge structures, the structure of the magnetic induction module can also make corresponding changes to the differential output of the half-bridge structure and the full-bridge structure, the sensitivity direction setting of each bridge arm, the setting of two or more magnetic induction units, etc. according to the specific application situation on the basis of the same principle, thereby forming a magnetic induction module with other bridge structures. Optionally, each of the above magnetoresistive bridge arms is formed by connecting one or more magnetoresistive sensitive elements in series and parallel.

The following is a brief description of the closed-loop negative feedback signal conditioning circuit in the magnetic induction module. Optionally, the magnetic induction module also includes a signal conditioning circuit, and the signal conditioning circuit adopts one of an open-loop signal conditioning circuit and a closed-loop signal conditioning circuit.

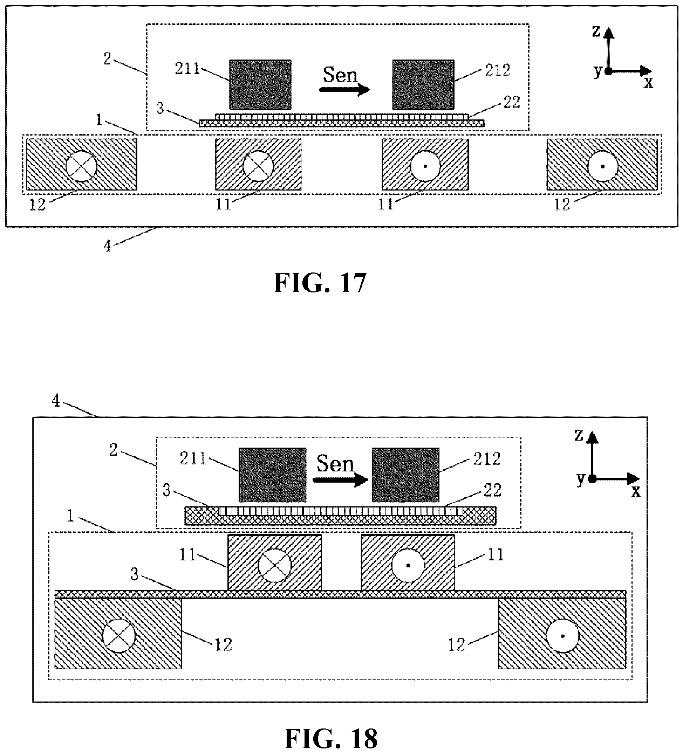

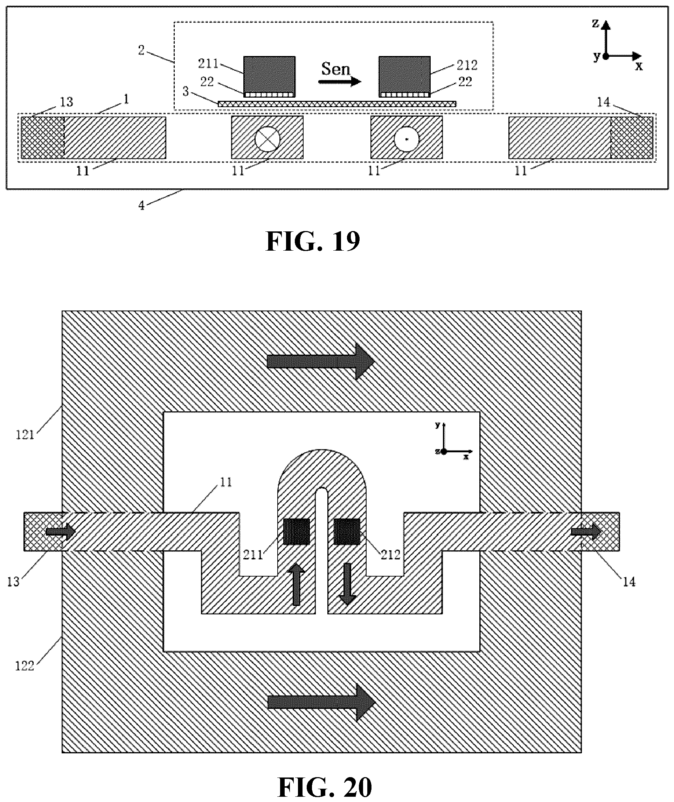

Refer to FIG. 17, which is a schematic diagram of a current sensor provided in an embodiment of the present invention. Refer to FIG. 18, which is a schematic diagram of another current sensor provided in an embodiment of the present invention. Refer to FIG. 19, which is a schematic diagram of yet another current sensor provided in an embodiment of the present invention. Optionally, the magnetic induction module 2 includes a first magnetic induction unit 211 and a second magnetic induction unit 212. The closed-loop signal conditioning circuit uses a magnetic field feedback coil 22. The closed-loop signal conditioning circuit, the magnetic field feedback coil 22, the first magnetic induction unit 211, and the second magnetic induction unit 212 constitute a closed-loop magnetic field feedback. The differential voltage signal of the bridge structure in the above magnetic induction module is amplified and then generates a feedback magnetic field by driving the magnetic field feedback coil 22. The feedback magnetic field reversely offsets the magnetic field difference (i.e., the differential mode magnetic field) generated by the primary-side current input copper bar 1 at the positions of the first magnetic induction unit 211 and the second magnetic induction unit 212. When the magnetic field dynamic balance is achieved, the first magnetic induction unit 211 and the second magnetic induction unit 212 operate under the same common mode magnetic field conditions, and the feedback current of the magnetic field feedback coil 22 is sampled through a sampling resistor to form the output of the magnetic induction module 2. The primary-side current input copper bar further includes a current shunting copper bar area 12, a primary-side input terminal 13, and a primary-side output terminal 14.

Optionally, the magnetic field feedback coil 22 is integrated inside the closed-loop signal conditioning circuit, or inside the circuit board 3, or inside a magnetic induction unit, or inside an ASIC dedicated integrated circuit, or inside the magnetic induction module 2. When the magnetic field feedback coil 22 is integrated into different positions, the working principle is the same, and the operation of the closed-loop magnetic field negative feedback is not affected.

As shown in FIG. 17, optionally, the magnetic field feedback coil 22 is integrated inside the magnetic induction module 2, and the plane where the magnetic field feedback coil 22 is located is parallel to the plane where the first magnetic induction unit 211 and the second magnetic induction unit 212 are located. The magnetic field feedback coil 22 is symmetrically distributed on both sides of the center line of the U-shaped current conduction path of the differential copper bar area 11 in the primary-side current input copper bar 1 in the cross section shown in FIG. 17; moreover, the current direction of the magnetic field feedback coil 22 on one side of the center line is perpendicular to the paper surface and outward, and the current direction of the magnetic field feedback coil 22 on the other side of the center line is perpendicular to the paper surface and inward.

Taking the example that the magnetic field direction of the current to be measured is rightward at the position of the first magnetic induction unit 211 and leftward at the position of the second magnetic induction unit 212, in order to reversely offset the differential mode magnetic field generated by the current to be measured, the current direction of the conductor horizontally arranged under the first magnetic induction unit 211 of the magnetic field feedback coil 22 is perpendicular to the paper and outward, and the current direction of the conductor horizontally arranged under the second magnetic induction unit 212 of the magnetic field feedback coil 22 is perpendicular to the paper and inward. Therefore, the magnetic field feedback coil 22 generates a horizontally leftward feedback magnetic field at the first magnetic induction unit 211, and the magnetic field feedback coil 22 generates a horizontally rightward feedback magnetic field at the second magnetic induction unit 212 to reversely offset the differential mode magnetic field generated by the current to be measured, thereby achieving dynamic balance of the magnetic field.

As shown in FIG. 18, optionally, the magnetic field feedback coil 22 is integrated inside the circuit board 3. As shown in FIG. 19, the optional magnetic field feedback coil 22 is integrated inside the first magnetic induction unit 211 and the second magnetic induction unit 212. In other embodiments, the magnetic field feedback coil may also be optionally integrated in other locations, not limited to the locations shown in the above figures. Although the distribution or connection of the magnetic field feedback coil is slightly different, the feedback magnetic field generated by the magnetic field feedback coil is always used to offset the differential mode magnetic field generated by the current to be measured, and finally the detection of the current to be measured is achieved.

Based on the above structure, the overall structure of the current sensor provided by the embodiment of the present invention is briefly summarized.

An embodiment of the present invention provides a first current sensor as shown in FIG. 7, a cross-sectional view of which is shown in FIG. 17, the current sensor includes a primary-side current input copper bar 1, a magnetic induction module 2, a circuit board 3, and a mechanical support housing 4; the primary-side current input copper bar 1 includes a differential copper bar area 11 containing a U-shaped current conduction path, a current shunting copper bar area 12, a primary-side input terminal 13, and a primary-side output terminal 14. The primary-side current input copper bar 1 may be an integrally formed copper bar, that is, the differential copper bar area 11, the current shunting copper bar area 12, the primary-side input terminal 13 and the primary-side output terminal 14 are located in the same horizontal plane. Optionally, the differential copper bar area 11 and the current shunting copper bar area 12 are connected in parallel, and the connection points at two ends are the primary-side input terminal 13 and the primary-side output terminal 14, respectively. After the current to be measured flows into the primary-side input terminal 13, it is shunted through the differential copper bar area 11 and the current shunting copper bar area 12, and flows out from the primary-side output terminal 14. The mechanical support housing 4 plays a role in wrapping, fixing, and supporting various parts in the current sensor. The magnetic induction module 2 is secured on the circuit board 3, and both are electrically isolated from the primary-side current input copper bar 1.

The magnetic induction module 2 includes a first magnetic induction unit 211 and a second magnetic induction unit 212 which are located in the same horizontal plane and have sensitivity directions both pointing horizontally to the right. The first magnetic induction unit 211 and the second magnetic induction unit 212 are respectively located above two current conduction paths with a parallel position relationship in the U-shaped current conduction path of the differential copper bar area 11, wherein, optionally, the current direction of the current conduction path below the first magnetic induction unit 211 is perpendicular to the paper plane and inward, and the current direction of the current conduction path below the second magnetic induction unit 212 is perpendicular to the paper plane and outward.

The magnetoresistive sensitive elements used by the first magnetic induction unit 211 and the second magnetic induction unit 212 are both tunnel magnetoresistors TMR. As shown in FIG. 13, the two magnetic induction units each include a magnetoresistive bridge arm, and the first magnetic induction unit 211 and the second magnetic induction unit 212 together constitute the same single-bridge differential half-bridge structure, which senses the differential-mode magnetic field generated by the primary-side current input copper bar 1 in a differential manner and generates a differential voltage signal. The magnetic induction module 2 adopts a closed-loop signal conditioning circuit. The closed-loop signal conditioning circuit, the magnetic field feedback coil 22 integrated in the magnetic induction module 2, the first magnetic induction unit 211, and the second magnetic induction unit 212 together constitute a closed-loop magnetic field feedback. The output of the magnetic induction module 2 forms the output signal of the current sensor.

An embodiment of the present invention provides a second current sensor as shown in FIG. 9, a cross-sectional view of which is shown in FIG. 18, the current sensor includes a primary-side current input copper bar 1, a magnetic induction module 2, a circuit board 3, and a mechanical support housing 4; the primary-side current input copper bar 1 includes a differential copper bar area 11 containing a U-shaped current conduction path, a current shunting copper bar area 12, a primary-side input terminal 13, and a primary-side output terminal 14.

Optionally, the current shunting copper bar area 12 is located below or above the plane where the differential copper bar area 11 is located. The differential copper bar area 11 and the current shunting copper bar area 12 are two independent copper bars that are connected in parallel, and the connection points at two ends are the primary-side input terminal 13 and the primary-side output terminal 14, respectively. Except for the connection points at two ends, the differential copper bar area 11 and the current shunting copper bar area 12 located in different planes are isolated from each other. After the current to be measured flows into the primary-side input terminal 13, it is shunted through the differential copper bar area 11 and the current shunting copper bar area 12, and flows out from the primary-side output terminal 14. The mechanical support housing 4 plays a role in wrapping, fixing, and supporting various parts in the current sensor. The magnetic induction module 2 is secured on the circuit board 3, and both are electrically isolated from the primary-side current input copper bar 1.

The magnetic induction module 2 includes a first magnetic induction unit 211 and a second magnetic induction unit 212 which are located in the same horizontal plane and have sensitivity directions both pointing horizontally to the right. The first magnetic induction unit 211 and the second magnetic induction unit 212 are respectively located above two current conduction paths with a parallel position relationship in the U-shaped current conduction path of the differential copper bar area 11, wherein, optionally, the current direction of the current conduction path below the first magnetic induction unit 211 is perpendicular to the paper plane and inward, and the current direction of the current conduction path below the second magnetic induction unit 212 is perpendicular to the paper plane and outward.

The magnetoresistive sensitive elements used by the first magnetic induction unit 211 and the second magnetic induction unit 212 are both giant magnetoresistors GMR. As shown in FIG. 14, the two magnetic induction units each include two magnetoresistive bridge arms, and the first magnetic induction unit 211 and the second magnetic induction unit 212 together constitute the same single-bridge differential full-bridge structure, which senses the differential-mode magnetic field generated by the primary-side current input copper bar 1 in a differential manner and generates a differential voltage signal. The magnetic induction module 2 adopts a closed-loop signal conditioning circuit. The closed-loop signal conditioning circuit, the magnetic field feedback coil 22 integrated in the magnetic circuit board 3, the first magnetic induction unit 211, and the second magnetic induction unit 212 together constitute a closed-loop magnetic field feedback. The output of the magnetic induction module 2 forms the output signal of the current sensor.

An embodiment of the present invention provides a third current sensor as shown in FIG. 11, a cross-sectional view of which is shown in FIG. 17. The current sensor includes a primary-side current input copper bar 1, a magnetic induction module 2, a circuit board 3, and a mechanical support housing 4. The primary-side current input copper bar 1 comprises a differential copper bar area 11 having a U-shaped current conduction path, a current shunting copper bar area 12, a primary-side input terminal 13, and a primary-side output terminal 14. Optionally, the primary-side current input copper bar 1 is an integrally formed copper bar, that is, the differential copper bar area 11, the current shunting copper bar area 12, the primary-side input terminal 13, and the primary-side output terminal 14 are located in the same horizontal plane. The main difference between FIG. 11 and FIG. 7 is that the differential copper bar area 11 in the current sensor shown in FIG. 11 connects the two ends of the U-shaped opening of the U-shaped current conduction path through another third current conduction path 111, and the part of the current to be measured passing through the differential copper bar area 11 is shunted again, further reducing the magnetic field generated by the current to be measured at the magnetic induction module 2.

As shown in FIG. 15, the first magnetic induction unit 211 adopts a push-pull half-bridge structure and forms a voltage output signal, the second magnetic induction unit 212 adopts a push-pull half-bridge structure and forms a voltage output signal, the two push-pull half-bridge structures form a double push-pull half-bridge differential structure, and the voltage outputs of the two push-pull half-bridge structures form a differential voltage signal. The magnetic induction module 2 adopts a closed-loop signal conditioning circuit consistent with the first current sensor and forms a closed-loop magnetic field feedback. The output of the magnetic induction module 2 forms the output signal of the current sensor.

An embodiment of the present invention provides a fourth current sensor as shown in FIG. 19, a top view of which is shown in FIG. 20, the current sensor includes a primary-side current input copper bar 1, a magnetic induction module 2, a circuit board 3, and a mechanical support housing 4 as shown in FIG. 20; the primary-side current input copper bar 1 includes a differential copper bar area 11 containing a U-shaped current conduction path, two current shunting copper bar areas 121 and 122, a primary-side input terminal 13, and a primary-side output terminal 14. Optionally, the primary-side current input copper bar 1 is an integrally formed copper bar, that is, the differential copper bar area 11, the two current shunting copper bar areas 121 and 122, the primary-side input terminal 13, and the primary-side output terminal 14 are located in the same horizontal plane. The differential copper bar area 11 and the current shunting copper bar areas 121 & 122 are connected in parallel, and the connection points at two ends are the primary-side input terminal 13 and the primary-side output terminal 14, respectively. After the current to be measured flows into the primary-side input terminal 13, it is shunted through the differential copper bar area 11 and the current shunting copper bar areas 121 and 122, and flows out from the primary-side output terminal 14. The mechanical support housing 4 plays a role in wrapping, fixing, and supporting various parts in the current sensor.

The magnetic induction module 2 is secured on the circuit board 3, and both are electrically isolated from the primary-side current input copper bar 1. The magnetic induction module 2 includes a first magnetic induction unit 211 and a second magnetic induction unit 212 which are located in the same horizontal plane and have sensitivity directions pointing horizontally to the right. As shown in FIG. 19, the first magnetic induction unit 211 and the second magnetic induction unit 212 are respectively located above two current conduction paths with a parallel position relationship in the U-shaped structure of the differential copper bar area 11, wherein the current direction of the current conduction path below the first magnetic induction unit 211 is perpendicular to the paper plane and inward, and the current direction of the current conduction path below the second magnetic induction unit 212 is perpendicular to the paper plane and outward.

The magnetoresistance sensitive elements adopted by the first magnetic induction unit 211 and the second magnetic induction unit 212 are both tunnel magnetoresistors TMR. Each magnetic induction unit includes a push-pull full-bridge structure composed of four magnetoresistive bridge arms. As shown in FIG. 16, the first magnetic induction unit 211 adopts a push-pull full-bridge structure and forms a voltage output signal, and the second magnetic induction unit 212 adopts a push-pull full-bridge structure and forms a voltage output signal. The two push-pull full-bridge structures form a double push-pull full-bridge differential structure, and the voltage outputs of the two push-pull full-bridge structures form a differential voltage signal. The magnetic induction module 2 adopts a closed-loop signal conditioning circuit. The closed-loop signal conditioning circuit, the magnetic field feedback coil 22 integrated in the magnetic induction unit, the first magnetic induction unit 211, and the second magnetic induction unit 212 constitute a closed-loop magnetic field feedback. The output of the magnetic induction module 2 forms the output signal of the current sensor.

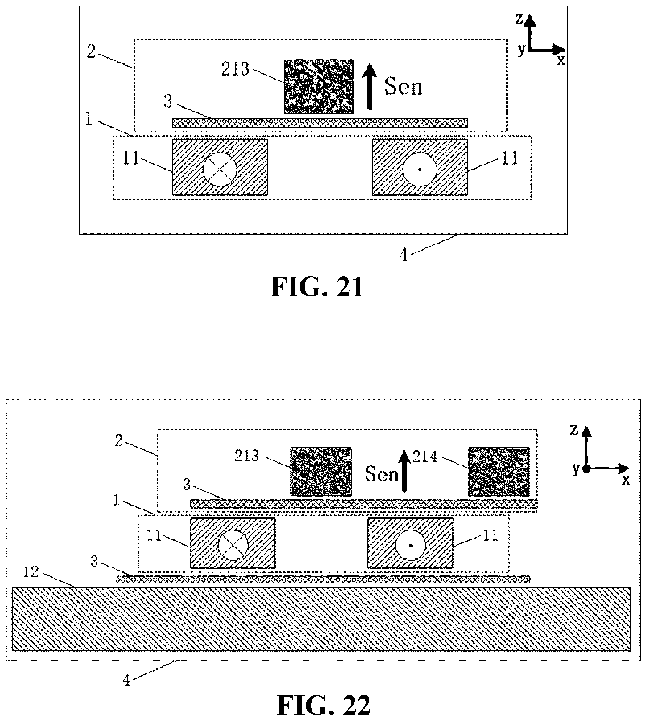

An embodiment of the present invention provides a fifth current sensor as shown in FIG. 4, a cross-sectional view of the location where its magnetic induction unit is located is shown in FIG. 21, and the current sensor includes a primary-side current input copper bar 1, a magnetic induction module 2, a circuit board 3, and a mechanical support housing 4; the primary-side current input copper bar 1 includes a differential copper bar area 11 containing a U-shaped current conduction path, a current shunting copper bar area 12, a primary-side input terminal 13, and a primary-side output terminal 14.

Optionally, the primary-side current input copper bar 1 is an integrally formed copper bar, and the differential copper bar area 11, the current shunting copper bar area 12, the primary-side input terminal 13, and the primary-side output terminal 14 are located in the same horizontal plane. The differential copper bar area 11 and the current shunting copper bar area 12 are connected in parallel, and the connection points at two ends are the primary-side input terminal 13 and the primary-side output terminal 14, respectively. After the current to be measured flows into the primary-side input terminal 13, it is shunted through the differential copper bar area 11 and the current shunting copper bar area 12, and flows out from the primary-side output terminal 14. The mechanical support housing 4 plays a role in wrapping, fixing, and supporting various parts in the current sensor.

The magnetic induction module 2 is secured on the circuit board 3, and both are electrically isolated from the primary-side current input copper bar 1. The magnetic induction module 2 includes a third magnetic induction unit 213 with a sensitivity direction vertically upward, and the third magnetic induction unit 213 uses a Hall element. As shown in FIG. 21, the vertical projection position of the third magnetic induction unit 213 is located inside the U-shaped enclosed area of the U-shaped current conduction path, the current direction of the left current conduction path below it is perpendicular to the paper surface and inward, and the current direction of the right current conduction path below it is perpendicular to the paper surface and outward. The current to be measured generates a vertically downward magnetic field at the position of the third magnetic induction unit 213. The magnetic induction module 2 adopts an open-loop signal conditioning circuit, and the output of the magnetic induction module 2 forms the output signal of the current sensor.

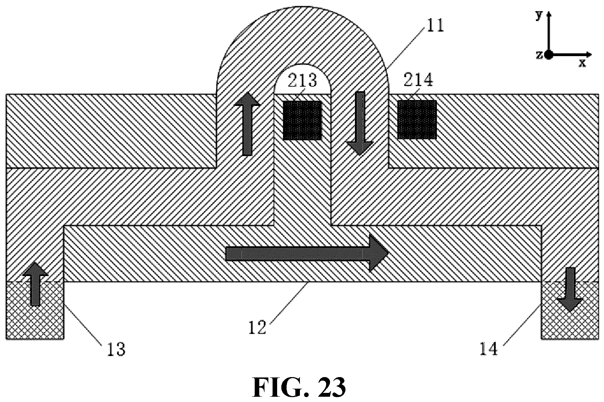

An embodiment of the present invention provides a sixth current sensor as shown in FIG. 23, a cross-sectional view of the location where its magnetic induction unit is located is shown in FIG. 22, and the current sensor includes a primary-side current input copper bar 1, a magnetic induction module 2, a circuit board 3, and a mechanical support housing 4; the primary-side current input copper bar 1 includes a differential copper bar area 11 containing a U-shaped current conduction path, a current shunting copper bar area 12, a primary-side input terminal 13, and a primary-side output terminal 14.

The current shunting copper bar area 12 is located below the plane where the differential copper bar area 11 is located. The differential copper bar area 11 and the current shunting copper bar area 12 are two independent copper bars that are connected in parallel, and the connection points at two ends are the primary-side input terminal 13 and the primary-side output terminal 14, respectively. Except for the connection points at two ends, the differential copper bar area 11 and the current shunting copper bar area 12 located in different planes are isolated from each other. After the current to be measured flows into the primary-side input terminal 13, it is shunted through the differential copper bar area 11 and the current shunting copper bar area 12, and flows out from the primary-side output terminal 14. The mechanical support housing 4 plays a role in wrapping, fixing, and supporting various parts in the current sensor.

The magnetic induction module 2 is secured on the circuit board 3, and both are electrically isolated from the primary-side current input copper bar 1. The magnetic induction module 2 includes a third magnetic induction unit 213 and a fourth magnetic induction unit 214 located in the same horizontal plane and with their sensitivity directions pointing vertically upward. The third magnetic induction unit 213 and the fourth magnetic induction unit 214 both use Hall elements. As shown in FIG. 22, the vertical projection position of the third magnetic induction unit 213 is located inside the U-shaped enclosed area of the U-shaped current conduction path, the current direction of the left current conduction path below it is perpendicular to the paper surface and inward, and the current direction of the right current conduction path below it is perpendicular to the paper surface and outward. The current to be measured generates a vertically downward magnetic field at the position of the third magnetic induction unit 213. The vertical projection position of the fourth magnetic sensing unit 214 is located outside the U-shaped enclosed area of the U-shaped current conducting path.

The magnetic induction module 2 adopts an open-loop signal conditioning circuit to condition, amplify, and perform temperature compensation and linearity correction on the differential voltage signals of the third magnetic induction unit 213 and the fourth magnetic induction unit 214. The output of the magnetic induction module 2 forms the output signal of the current sensor.

In summary, the current sensor provided by the embodiments of the present invention has a large current measurement range, electrically isolates input and output, can measure AC and DC currents, has adjustable sensitivity, and has strong resistance to external magnetic field interference. Compared with the prior art, the advantages of the current sensor provided by the embodiments of the present invention are as follows: the current measurement range is regulated by parallel shunting the U-shaped structure current conduction path; therefore, the current input range can be regulated by controlling the structure, quantity, and plane of the current shunting copper bar area, thereby achieving large current measurement without an iron core and reducing the volume and weight; further, the design of the current sensor is simplified by adopting integrated processing, the structure is simple, and the production cost is reduced. The current sensor provided by the embodiments of the present invention is applicable to a magnetic induction unit whose magnetic field sensitivity direction is perpendicular to or parallel to the plane where the magnetic induction module is located. Its advantages are particularly reflected in the measurement of magnetoresistive devices with high sensitivity and small saturation field such as GMR and TMR, which expands the measurement range of magnetoresistive devices with high sensitivity and small saturation field. The current sensor has the characteristics of input and output electrical isolation, capability of measuring AC and DC currents, adjustable sensitivity, and strong resistance to external magnetic field interference.

It should be noted that the above description is merely the preferred embodiments and adopted technical principles of the present invention. A person skilled in the art should understand that the present invention is not limited to the specific embodiments herein, and for a person skilled in the art, various obvious variations, readjustments, mutual combinations, and replacements may be made without departing from the protection scope of the present invention. Therefore, although the present invention has been described in detail with the above embodiments, the present invention is not limited to the above embodiments. Without departing from the concept of the present invention, more other equivalent embodiments can also be included, and the scope of the present invention is defined by the appended claims.

## Claims

1. A current sensor, **characterized in that** it comprises:
a primary-side current input copper bar,
a magnetic induction module, and
a circuit board;
the primary-side current input copper bar comprises
a primary-side input terminal,
a primary-side output terminal,
a differential copper bar area, and
a current shunting copper bar area;
the differential copper bar area and the current shunting copper bar area are electrically connected in parallel, the differential copper bar area includes a U-shaped current conduction path, the number of the current shunting copper bar areas is one or more, and any of the current shunting copper bar areas and the differential copper bar area are located in the same horizontal plane or different horizontal planes;
the number of the primary-side input terminals is one or more, the number of the primary-side output terminals is one or more, and any of the primary-side input terminals and the primary-side output terminals is electrically connected to the differential copper bar area or to the current shunting copper bar area;
the primary-side current input copper bar is formed in one of the following two ways:
(1) integrally formed; and
(2) formed by connecting more than one independent copper bar,
wherein the independent copper bar includes part or all of the primary-side input terminal, the primary-side output terminal, the differential copper bar area, and the current shunting copper bar area;
the magnetic induction module is secured on the circuit board and is located above the U-shaped current conduction path in the differential copper bar area, and the output of the magnetic induction module forms the output signal of the current sensor.

2. The current sensor according to claim 1, **characterized in that** the magnetic induction module adopts one of the following three situations:
(1) the magnetic induction module includes at least a first magnetic induction unit and a second magnetic induction unit therein, the first magnetic induction unit and the second magnetic induction unit are located respectively above two current conduction paths with a parallel position relationship in the U-shaped current conduction path, the first magnetic induction unit and the second magnetic induction unit sense the magnetic field generated by the primary-side current input copper bar in a differential manner and generate a differential voltage signal, and the magnetic field sensitivity direction of the magnetic induction unit used by the current sensor is parallel to the plane where the magnetic induction module is located;
(2) the magnetic induction module includes at least a third magnetic induction unit therein, the vertical projection position of the third magnetic induction unit is located at the internal side of the U-shaped enclosed area of the U-shaped current conduction path, the third magnetic induction unit directly senses the magnetic field generated by the primary-side current input copper bar and generates a voltage signal, and the magnetic field sensitivity direction of the magnetic induction unit used by the current sensor is perpendicular to the plane where the magnetic induction module is located; and
(3) the magnetic induction module includes at least the third magnetic induction unit and a fourth magnetic induction unit therein, the vertical projection position of the fourth magnetic induction unit is located at an external side of the U-shaped enclosed area of the U-shaped current conduction path, the third magnetic induction unit and the fourth magnetic induction unit sense the magnetic field generated by the primary-side current input copper bar in a differential manner and generate a differential voltage signal, and the magnetic field sensitivity direction of the magnetic induction unit used by the current sensor is perpendicular to the plane where the magnetic induction module is located.

3. The current sensor according to claim 2, **characterized in that** the first magnetic induction unit and the second magnetic induction unit each include one or more magnetoresistive bridge arms, and each of the magnetoresistive bridge arms is composed of one or more magnetoresistive sensitive elements connected in series and in parallel;
in the first magnetic induction unit and the second magnetic induction unit, the bridge structure adopted by any magnetic induction unit is one of a differential half-bridge structure, a differential full-bridge structure, a double push-pull half-bridge differential structure, and a double push-pull full-bridge differential structure:
(1) the differential half-bridge structure is a single bridge, and the first magnetic induction unit and the second magnetic induction unit together constitute the same single-bridge differential half-bridge structure and form an output signal of the differential half-bridge structure;
(2) the differential full-bridge structure is a single bridge, and the first magnetic induction unit and the second magnetic induction unit together constitute the same single-bridge differential full-bridge structure and form an output signal of the differential full-bridge structure;
(3) in the double push-pull half-bridge differential structure, the first magnetic induction unit and the second magnetic induction unit both adopt a push-pull half-bridge structure and each form a voltage output signal, and the voltage output signals of the two push-pull half-bridge structures differentially form an output signal of the double push-pull half-bridge differential structure; and
(4) in the double push-pull full-bridge differential structure, the first magnetic induction unit and the second magnetic induction unit both adopt a push-pull full-bridge structure and each form a voltage output signal, and the voltage output signals of the two push-pull full-bridge structures differentially form an output signal of the double push-pull full-bridge differential structure.

4. The current sensor according to claim 1, **characterized in that** two ends of the U-shaped opening of the U-shaped current conduction path are electrically connected.

5. The current sensor according to claim 1, **characterized in that** the primary-side current input copper bar is electrically isolated from the magnetic induction module and the circuit board, respectively.

6. The current sensor according to claim 1, **characterized in that** the magnetic induction module further comprises a signal conditioning circuit, and the signal conditioning circuit adopts one of an open-loop signal conditioning circuit and a closed-loop signal conditioning circuit.

7. The current sensor according to claim 1, **characterized by** further comprising a mechanical support housing, wherein the mechanical support housing plays a role in wrapping, fixing, and supporting various parts in the current sensor.
